# EUROPEAN PATENT APPLICATION

(11) **EP 4 550 389 A1**
(43) Date of publication of application: **07.05.2025**
(21) Application number: 24204795.9
(22) Date of filing: 04.10.2024
(51) Int. Cl.: H01L 21/308, H01L 21/027, H01L 21/033, H01L 21/3065, H01L 21/266, H01L 21/28

(54) **METHOD FOR FORMING A REDUCED SIZE FEATURE**

(30) Priority: 27.10.2023 US 202318496227
(71) Applicant: NXP USA, Inc., Austin TX 78735 (US)
(72) Inventor: REBER, Douglas Michael, 5656AG Eindhoven (NL)
(74) Representative: Hardingham, Christopher Mark

(57) **Abstract**

A method for forming features on a wafer that includes forming a first opening in a first layer over a layer including carbon and removing material of the layer including carbon through the first opening to form a cavity. The method includes forming spacer material on the sidewalls of the layer including carbon in the cavity with a material forming process, wherein the spacer material is inhibited from forming on the bottom surface portion of the cavity during the material forming process. The formed spacer material formed a spacer that defines a second opening that is has a smaller lateral dimension in a first lateral direction than the first opening.

## Description

### BACKGROUND OF THE INVENTION

### Field of the Invention

This invention relates in general to a method for forming reduced size features by forming spacer material on a sidewall of a carbon containing layer.

### Description of the Related Art

Semiconductor device manufacturing involves forming openings and structures on a wafer using photolithographic processes. In a photolithographic process, a patterned layer of photoresist is used to define the edges of openings or structures. A critical dimension of a semiconductor manufacturing process is the smallest dimension that can be lithographically defined given the capabilities of the processing equipment of that process. Over the years, achievable critical dimensions have decreased has semiconductor processing technology has advanced. Currently, some advanced processes have a critical dimension of less than 5 nm.

### BRIEF DESCRIPTION OF THE DRAWINGS

The present invention may be better understood, and its numerous objects, features, and advantages made apparent to those skilled in the art by referencing the accompanying drawings.
Figures 1-5 set forth partial cross-sectional side views of a semiconductor wafer during stages of its manufacture according to one embodiment of the present invention.
Figures 6-8 set forth partial cross-sectional side views of a semiconductor wafer during stages of its manufacture according to another embodiment of the present invention.
Figures 9-12 set forth partial cross-sectional side views of a semiconductor wafer during stages of its manufacture according to another embodiment of the present invention.
Figure 13 set forth a partial cross-sectional side view of a semiconductor wafer during a stage of its manufacture according to another embodiment of the present invention.
Figure 14 set forth a partial cross-sectional side view of a semiconductor wafer during a stage of its manufacture according to another embodiment of the present invention.

The use of the same reference symbols in different drawings indicates identical items unless otherwise noted. The figures are not necessarily drawn to scale.

### DETAILED DESCRIPTION

The following sets forth a detailed description of at least one mode for carrying out the invention. The description is intended to be illustrative of the invention and should not be taken to be limiting.

As disclosed herein, a method for forming features on a wafer that includes forming a first opening in a first layer over a layer including carbon and removing material of the layer including carbon through the first opening to form a cavity. The method includes forming spacer material on the sidewalls of the layer including carbon in the cavity with a material forming process, wherein the spacer material is inhibited from forming on the bottom surface portion of the cavity during the material forming process. The formed spacer material formed a spacer that defines a second opening that is has a smaller lateral dimension in a first lateral direction than the first opening.

In some embodiments, providing a method that forms spacer material on a sidewall of a cavity in a layer including carbon but is inhibited from forming on a bottom surface portion of the cavity may provide for a method that forms an opening that is smaller than a photographically defined opening used to form the cavity. Accordingly, in some embodiments, the method can be used to form features that are smaller than the critical dimension of a semiconductor process.

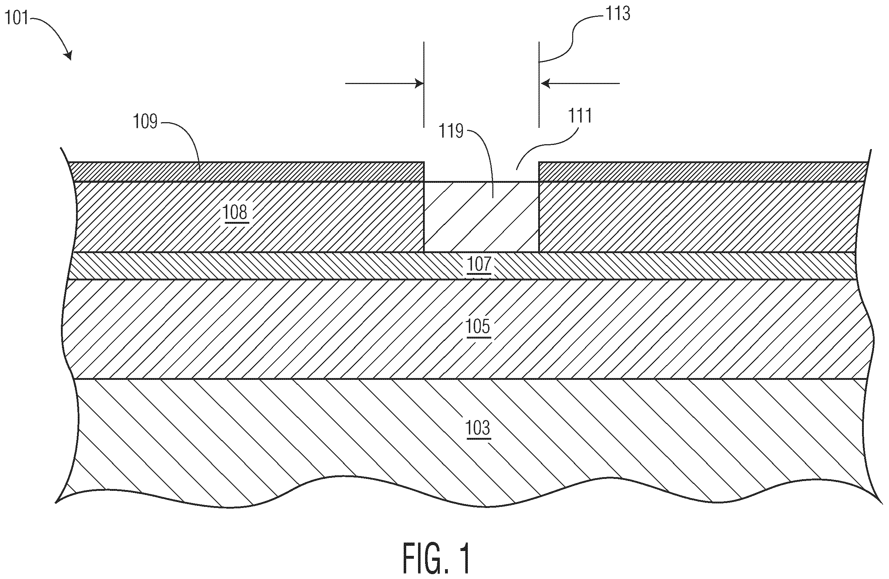

Figure 1 is a partial cross-sectional side view of a wafer 101 during a stage in its manufacture according to one embodiment of the present invention. Wafer 101 includes a substrate 103 that is made of one or more semiconductor materials such as e.g., monocrystalline silicon, silicon germanium, silicon carbide, gallium nitride, gallium arsenide, or other III-V semiconductor material. In one embodiment, substrate 103 has a bulk-semiconductor configuration. In other embodiments, substrate 103 may have an SOI (semiconductor on insulator) configuration. In some embodiments, substrate 103 is formed from a singulated portion of an integrally grown semiconductor material. In other embodiments, portions of substrate 103 may include epitaxially grown semiconductor material. Substrate 103 may also include dielectric structures (e.g., shallow trench isolation structures, buried oxide layers (not shown)).

Substrate 103 includes semiconductor regions for multiple semiconductor devices (e.g., transistors, diodes) of an integrated circuit (none are shown in Figure 1). In some embodiments, substrate 103 includes semiconductor regions for transistors such as e.g., FETs (field-effect transistors), bipolar transistors, JFETs (junction field-effect transistors), and FinFETs (not shown), stacked transistors, nanotube and multi-sheet transistors, as well as semiconductor regions for of other types of semiconductor devices such as e.g., diodes (not shown) and guard regions.

A layer 105 of amorphous carbon is formed over substrate 103. In one embodiment, layer 105 is 500 Angstroms thick but can have other thicknesses in other embodiments. In some embodiments, layer 105 is utilized as an anti-reflective coating that inhibits UV light from reflecting during a photolithographic process. In other embodiments, other types of layers with carbon may be used such as microcrystalline carbon or diamond-like carbon. In some embodiments, layer 105 may contain amounts of other materials in addition to the amorphous carbon such as e.g., hydrogen, nitrogen, fluorine, oxygen, silicon, chlorine, boron, aluminum, germanium, sulfur.

A layer 107 of silicon oxide is formed over layer 105. In one embodiment layer 107 is formed by a low temperature TEOS process and has a thickness of 200 Angstroms, but may be made of other process and have other thicknesses in other embodiments. A layer 108 of photoresist is formed over layer 107. In some embodiments, silicon dioxide layer 107 is used for proper adhesion of the photoresist to wafer 101 and for optical coupling to minimize reflections. In other words, the combination of the optical properties of the carbon layer 105 and the optical and physical properties of the capping oxide layer 107 allow for maximizing the anti-reflective properties of the stack for the photoresist exposure.

Layer 108 is patterned by a photolithographic process. In one embodiment of a photolithographic process, selective portions of layer 108 are exposed to UV light through openings (e.g., opening 111) in a mask 109. The UV light changes the properties of the exposed portions (e.g., portion 119) of photoresist layer 108. The different properties of the exposed portions (e.g., portion 119) and the unexposed portions of layer 108 allow for the selective removal of the exposed portions after UV exposure to form a patterned layer. Other types of photolithographic processes may be used in other embodiments. For example, the unexposed portions of photoresist may be removed where the exposed portions remain.

As shown in Figure 1, opening 111 in mask 109 has a lateral width 113. In some embodiments, the lateral width 113 is at the critical dimension of the semiconductor process used to process wafer 101.

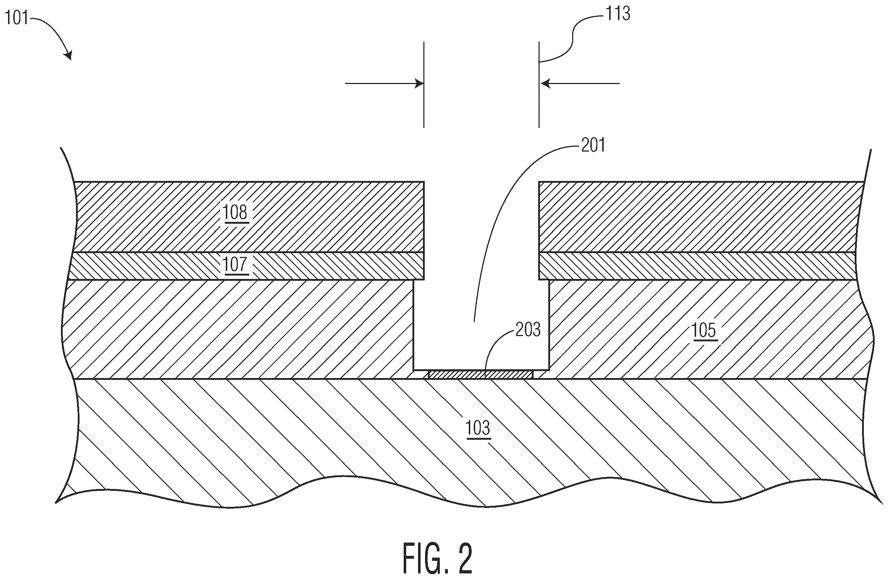

Figure 2 is a partial cutaway side view of wafer 101 after portion 119 (see Figure 1) has been removed from photoresist layer 108 and an anisotropic etch has been used to remove a portion of layer 107 exposed by the removal of the portion of layer 108. Afterwards, wafer 101 is subjected to a time isotropic etch to form cavity 201 in layer 105. In the embodiment shown, a portion of layer 105 forms the bottom part of cavity 201. In one embodiment, layer 105 may first be etched with a timed anisotropic etch to define vertical sidewalls conforming to the sidewalls of layer 108 and layer 107. The anisotropic etch is then followed by a time isotropic etch that widens cavity 201 beyond lateral width 113 to undercut layer 107. In one embodiment, the isotropic etch is performed with a plasma etch. In some embodiment, resist layer 108 can be removed after layer 107 has been etched.

After the formation of cavity 201, a bottom portion 203 of layer 105 is exposed to an a directional anisotropic hydrogenation plasma treatment that coats the surface of portion 203 with hydrogen. Because the sidewalls of cavity 201 are recessed due to the isotropic etching, they are not exposed to the hydrogen from the directional plasma treatment.

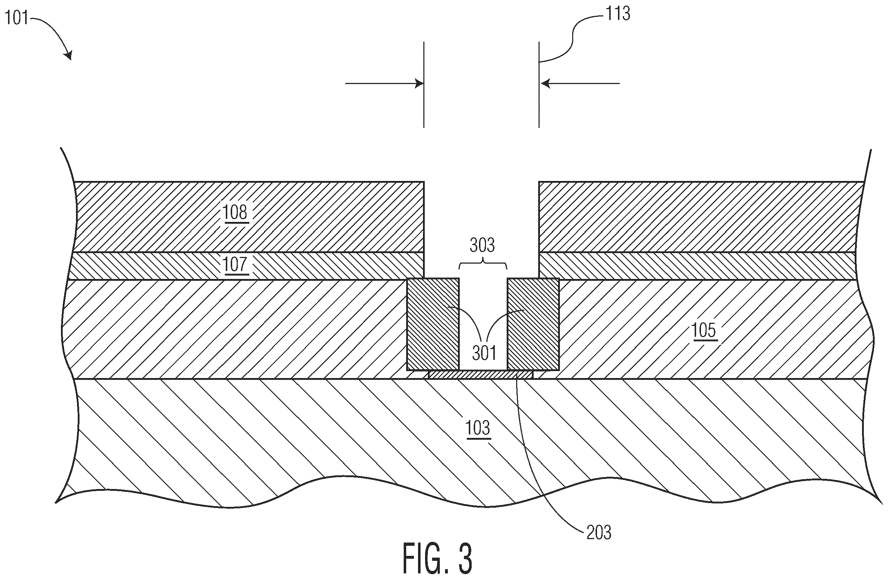

Figure 3 is a partial cross sectional side view of wafer 101 after sidewall spacers 301 are formed on the sidewalls of cavity 201. In one embodiment, spacer material is formed by an atomic layer deposition (ALD) process. In one embodiment, spacer 301 is formed of a spacer material (e.g., TiN, TiO₂, HfO₂, Ru, Pt, Al₂O₃) that forms on the carbon of layer 105 on the sidewalls of cavity 201. The spacer material is inhibited from adhering to the hydrogen treated portion 203 during the ALD process. Accordingly, spacer material should not form on a portion of portion 203. However, in some embodiments, wafer 101 may be subject to a short anisotropic etch with an etch chemistry that is selective with respect to the spacer material to remove any small amount of spacer material that may adhere to region 203 outside of sidewall spacer 301.

As shown in Figure 3, spacer 301 defines an opening 303. Opening 303 has a narrower lateral width than lateral width 113. The lateral width of opening 303 can be controlled by the number of atomic layers of the spacer material deposited in forming spacer 301. One advantage of using an ALD spacer-formation process is that the spacer width can be controlled with the relatively precise ALD process.

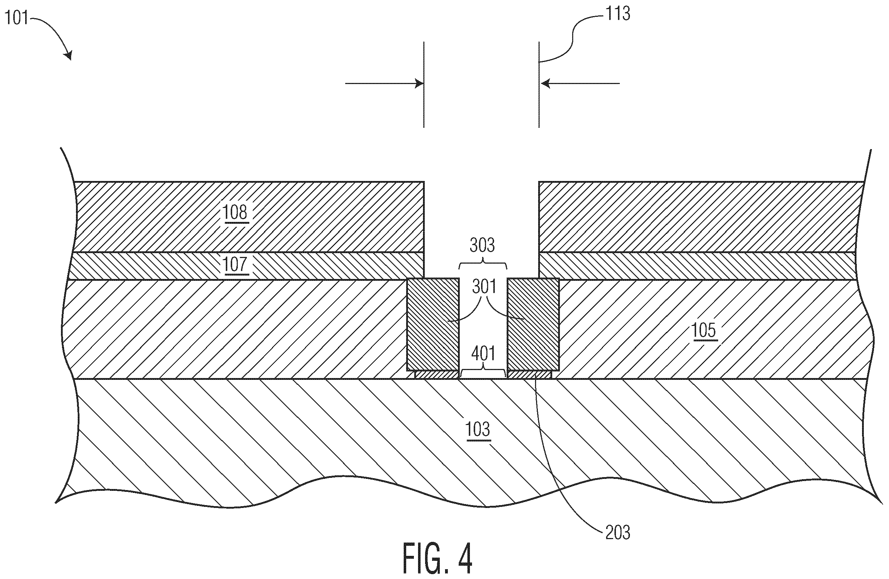

Figure 4 is a partial cross-sectional side view of wafer 101 after a portion of portion 203 has been anisotropically etched through opening 203 to expose surface 401 of substrate 103. Region 203 is etched with an etch chemistry that is selective with respect to the amorphous carbon and selective to the spacer material of spacer 301 and silicon oxide of layer 107. As shown in Figure 4, exposed surface 401 has the same lateral width as opening 303.

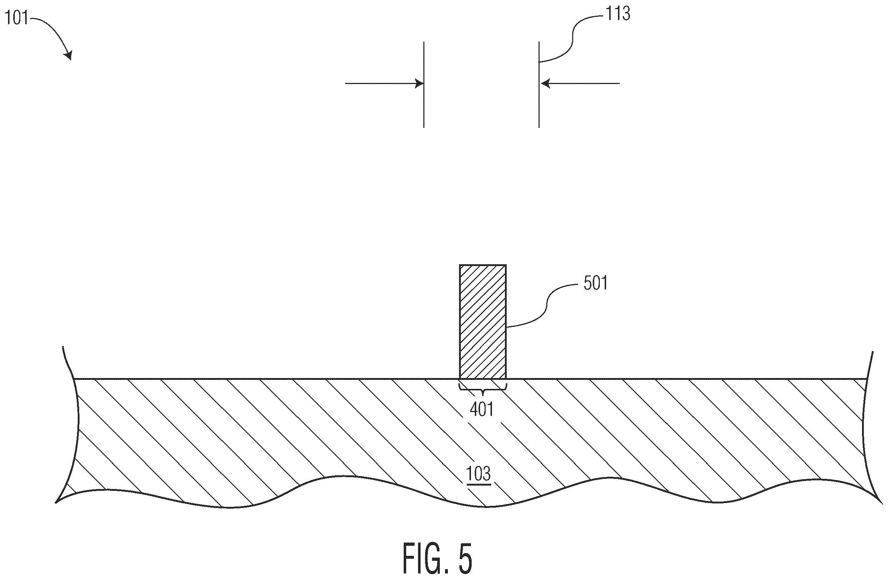

Figure 5 is a partial cross-sectional side view of wafer 101 after structure 501 has been formed on surface 401 of substrate 103. In one embodiment, structure 501 is a conductive structure (e.g., doped polysilicon, metal) that serves as a contact or as a terminal for a transistor (e.g., a gate for a FET). The FET may be a planar FET or a finFET where the view of Figure 5 is a cross-sectional view that transverses along the length of the fin. However, in other embodiments, structure 501 could be made of a dielectric or could be made of a monocrystalline semiconductor material epitaxially grown from surface 401.

In one embodiment after the stage of Figure 4, a layer of structure material (e.g., metal, polysilicon, dielectric) is formed on wafer 101 which fills opening 303. In other embodiments, semiconductor material may be epitaxially grown in opening 303. Wafer 101 is then planarized to the top of spacer 301. The remaining portion of layer 105 and sidewall spacer 301 is removed, leaving structure 501. In an embodiment where structure 501 is a gate for a FET, surface 401 may be oxidized to form a gate dielectric before forming the layer of material for structure 501. Also in other embodiments, a region of wafer 101 may be selectively implanted with dopants through opening 303 where layer 107, layer 105 and spacer 301 serve as an implant mask to prevent other areas from being implanted with dopants.

After the stage of Figure 5, other structures may be formed on wafer 101 including other conductive structures, doped regions, and dielectrics. Afterwards, an interconnect layer is formed over wafer 101 where the interconnect layer includes one or metal interconnect layers with conductive interconnects, conductive vias, and intervening dielectric material. External die terminals (e.g., bond pads, posts, pillars) are then formed on wafer 101. Wafer 101 is then singulated into multiple integrated circuits. The integrated circuits are then packaged to form packaged integrated circuits that are implemented in electronic systems such as e.g., TVs, computers, cell phones, appliances, automobiles, manufacturing equipment, or communications equipment.

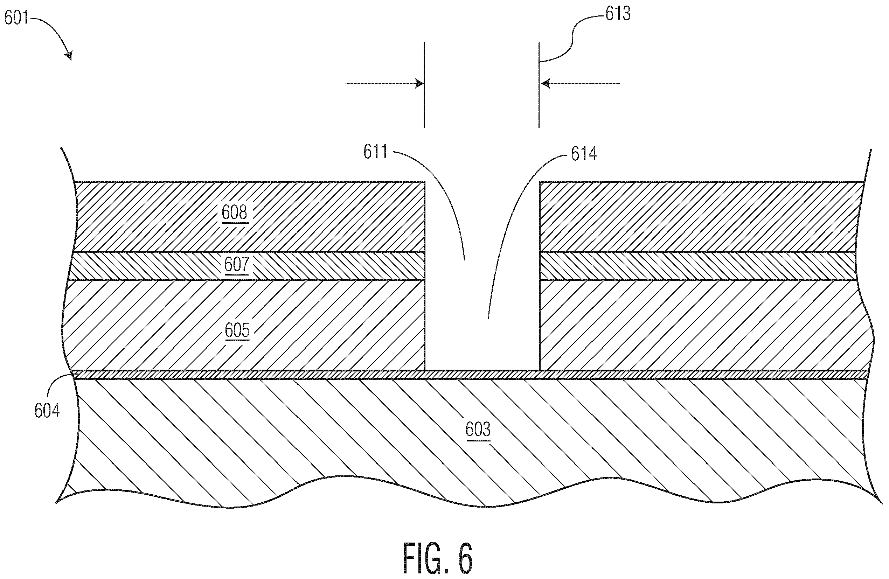

Figures 6-8 are partial cross-sectional side views of a wafer during various stages of manufacture according to another embodiment. Referring to Figure 6, in one embodiment, wafer 601 is similar to wafer 101 where substrate 603, amorphous carbon layer 605, silicon dioxide layer 607, and photoresist layer 608 are similar to substrate 103, layer 105, layer 107, and layer 108, respectively. Wafer 601 is different than wafer 101 in that a silicon dioxide layer 604 is located between layer 605 and substrate 603 which serves as an etch stop for the subsequent etching of the amorphous carbon layer 605.

As shown in Figure 6, a photolithographically defined opening 611 having a lateral width 613 is formed in layers 608, 607, and 605 that exposes silicon dioxide layer 604. In the embodiment shown, amorphous carbon layer 605 is anisotropically etched to form a cavity 614 in layer 605 such that the sidewalls of the cavity align with the sidewalls of layers 607 and 608. In some embodiments, resist layer 608 can be removed after layer 607 has been etched.

After the formation of opening 611, the exposed portion of layer 604 is treated with inhibitors such as a short-chain amino-silane (e.g., bis(N, N-dimethylamino) dimethylsilane (DMADMS) and (N, N-dimethylamino) trimethylsilane (DMATMS)) that acts to inhibit the subsequent formation of spacer material (e.g., Ru, Pt, Al₂O₃, HfO₂,) on layer 604 by an ALD process. The inhibitors are adsorbed on the SiO₂ surface of layer 604 but not on the amorphous carbon of layer 605, so that the treated SiO₂ surface becomes selectively deactivated toward a subsequent ALD process.

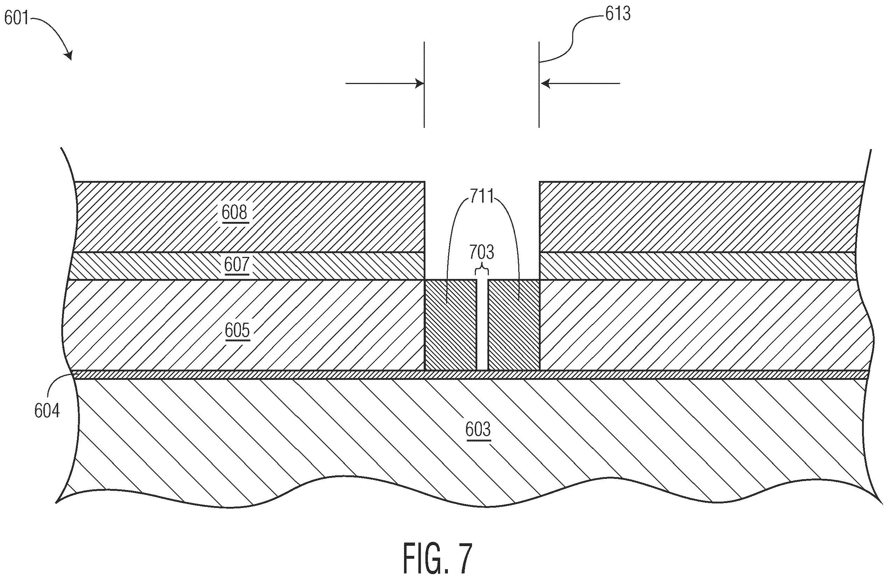

Figure 7 is a partial cross-sectional side view of wafer 601 after sidewall spacer 711 is formed on the sidewalls of layer 605. In one embodiment, spacer material is formed by an atomic layer deposition process. In one embodiment, spacer 711 is formed of a spacer material (e.g., HfO₂, Ru, Pt, Al₂O₃) that forms on the carbon of the carbon sidewalls of cavity 614 and does not form on a portion of layer 604 due to the previous treatment of inhibiting precursors. In some embodiments, wafer 601 may be subjected to a short anisotropic etch with an etch chemistry that is selective with respect to the spacer material to remove any small amount of spacer material that may adhere to layer 604 outside of sidewall spacer 301.

Spacer material is not located over a portion of layer 604 to define an opening 703. As shown in Figure 7, opening 703 has a narrower lateral width than lateral width 613. The lateral width of opening 703 can be controlled by the number of atomic layers deposited of the spacer material. One advantage of forming a feature that has a smaller lateral width than the critical dimension with an ALD spacer-formation process is that the ALD process is relatively precise allowing for accurate spacer width control.

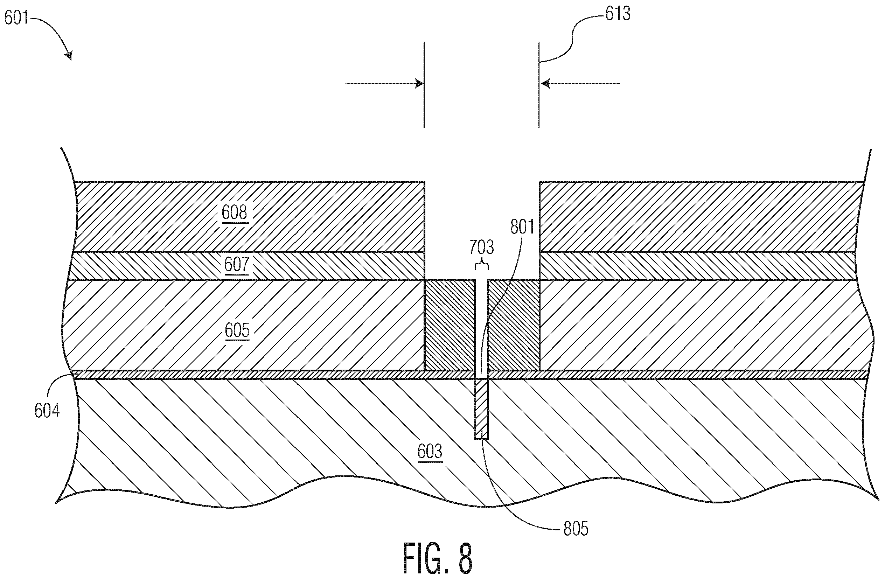

Figure 8 shows wafer 601 after an opening is formed in layer 604 and conductivity dopants (e.g., phosphorus, arsenic, boron) are implanted through opening 703 to form doped region 805 with layers 605, 607, and 608 and spacer 703 being used as an implant mask. Region 805 could be used as a terminal for a semiconductor device such as a base region for a bipolar transistor or a diode terminal. Region 805 could also be used as a guard region for noise isolation in substrate 603. In other embodiments, the area of region 805 could be etched to form a trench where the trench would be filled with a dielectric. In other embodiments, region 805 could be etched and filled with a conductive material (e.g., metal) for forming an inlaid via or metal trench in the substrate. In other embodiments, a silicide could be formed on region 805 after implantation and a conductive contact formed in opening 703. In still other embodiments, a gate structure could be formed in opening 703 as with the embodiment of Figures 1-5. Wafer 601 would be further processed to form multiple integrated circuits as described above.

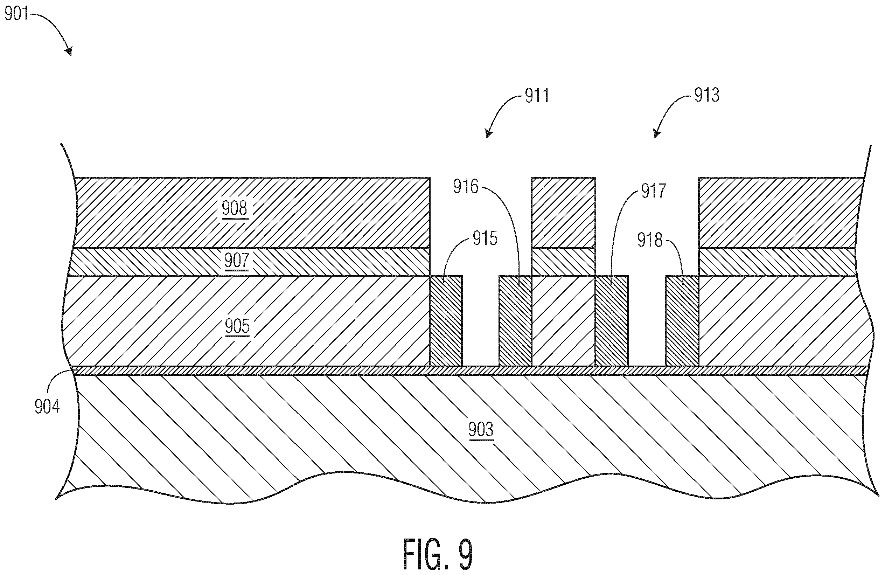

Figures 9-12 are partial cross-sectional side views of wafer 901 during various stages in its manufacture for making semiconductor fins. Wafer 901 is similar to wafer 601 where substrate 903, layer 904, layer 905, layer 907, and layer 908 are similar to substrate 603, layer 604, layer 605, layer 607, and layer 608. Shown in Figure 9 are two trench openings 911 and 913. Spacers similar to spacer 711 of Figure 7 are formed on the sidewalls of amorphous carbon layer 905 where spacer portions 915, 916, 917, and 918 are shown in Figure 9. In one embodiment, the spacers in openings 911 and 913 are formed by the processes of the embodiment of Figures 6-8, but may be formed by other processes such as the processes of the embodiment of Figures 1-5.

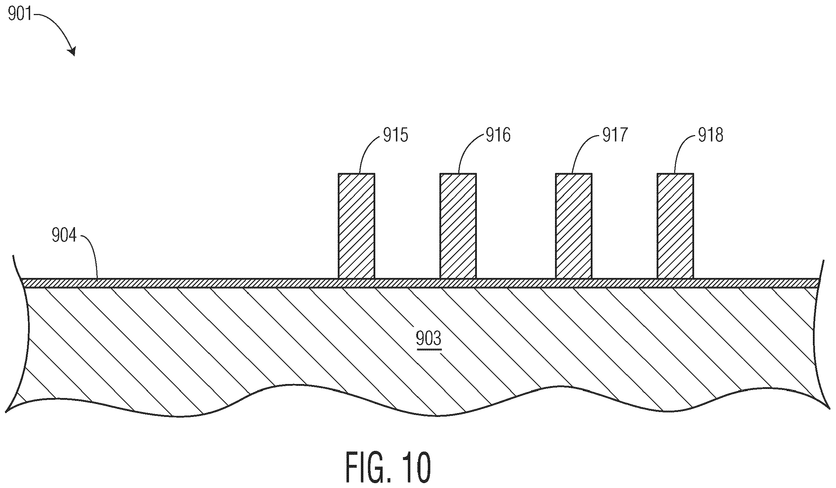

In Figure 10, layers 905, 907, and 908 are removed leaving portions 915-918. In one embodiment, portions 915-918 have a lateral width in the range of 10-40 percent of the width of the critical dimension, but may be of other percentages of the critical dimension in other embodiments.

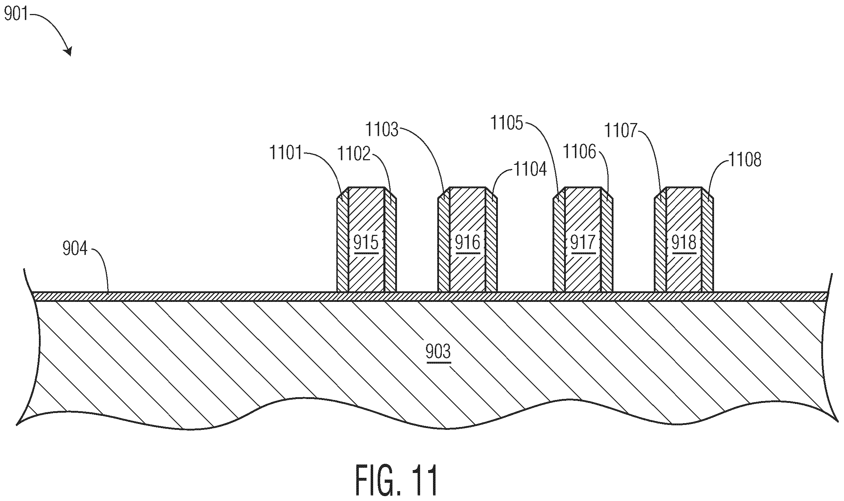

Figure 11 shows wafer 901 after sidewall spacer portions 1101 and 1102 are formed on portion 915, sidewall spacer portions 1103 and 1104 are formed on portion 916, sidewall spacer portions 1105 and 1106 are formed on portion 917, and sidewall spacer portions 1107 and 1108 are formed on portion 918. In one embodiment, portions 1011-1018 are formed by forming a layer of oxide or nitride over wafer 901 and anisotropically etching the layer to from the spacer portions. Portions 1101-1108 and portions 915-918 are physically separated from each other at the ends of the trenches (not shown) by a patterned etch.

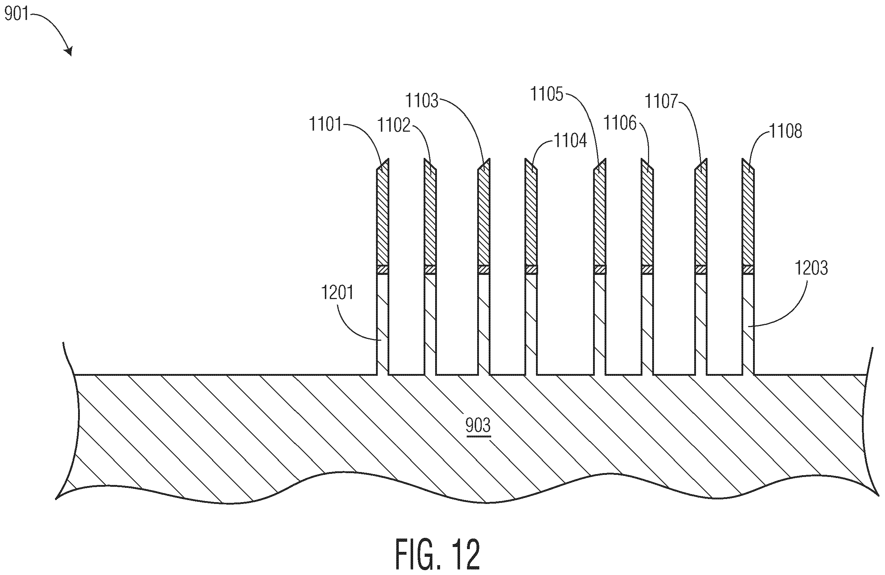

Figure 12 shows wafer 901 after portions 915-918 are removed and portions 1101-1108 are used to as a mask to form semiconductor fins (e.g., 1201 and 1203) by anisotropically etching substrate 903 with a timed etch. In one embodiment, depending upon the thickness of the layer used to formed portions 1101-1108, the fins may have a lateral thickness in the range of 2-20 percent of the critical dimension, although the fins may be of other percentages of the critical dimension in other embodiments.

After the stage of Figure 12, portions 1101-1108 are removed as well as the portions of layer 904 on top of the fins (e.g., 1201 and 1203). Gate structures (not shown) are formed over the fins (1201 and 1203) and then source and drain regions are formed by implanting dopants in the fins on opposite sides of the gates. Contacts (not shown) are then formed to contact the source regions, drain regions, and gate structures of the finFETs.

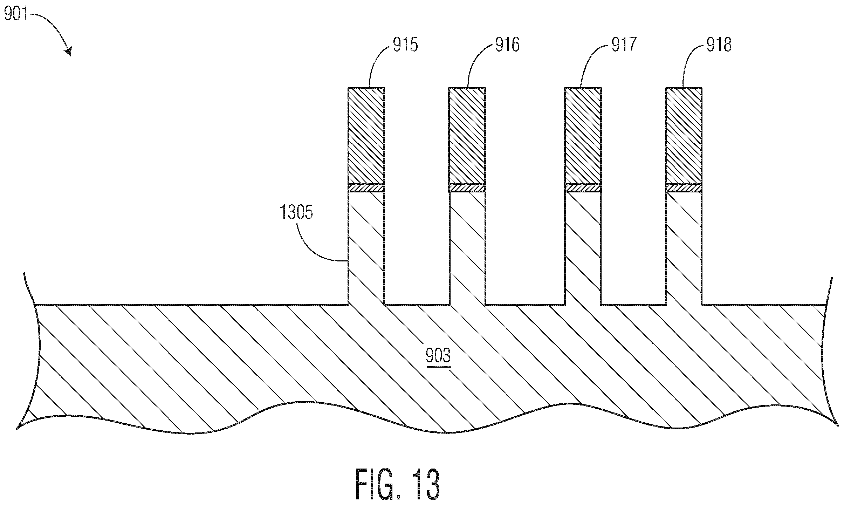

Figure 13 shows a partial cross-sectional side view of wafer 901 according to an alternative embodiment. The stage of the embodiment of Figure 13 follows the stage of Figure 10 where the sidewall portions 1101-1108 of Figure 11 are not formed in this embodiment. Instead portions 915-918 are used as an etch mask to form semiconductor fins (1305) by etching substrate 903. The lateral width of the fins is dependent upon the lateral width of portions 915-918. The fins (1305) are utilized in subsequently formed FinFETs (not shown).

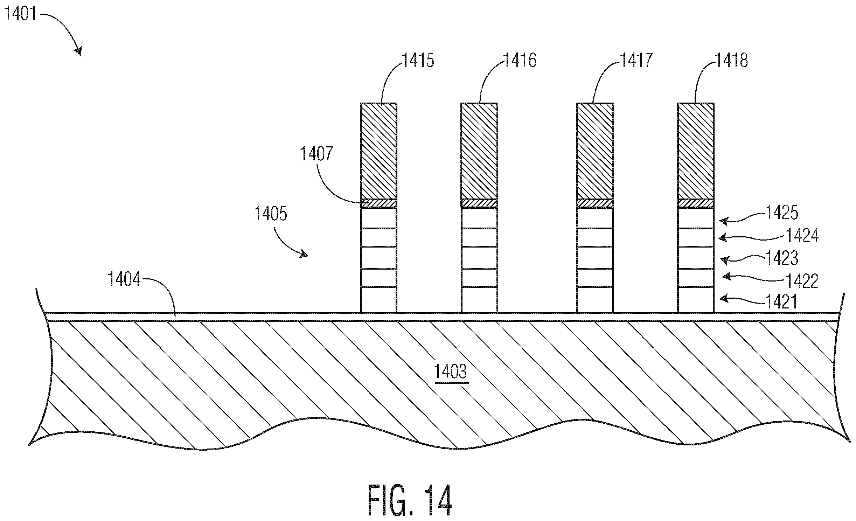

Figure 14 is a partial cross-sectional side view of wafer 1401 according to another embodiment of the present invention. In the embodiment shown, sidewall portions 1415-1418 are formed in a similar manner as sidewall portions 915-918 of Figure 9, although they may be formed by other processes such as the processes of the embodiment of Figures 1-5.

Wafer 1401 is different from wafer 901 of Figure 9 in that portions 1415-1418 are used as masks to pattern fins (1405) of semiconductor material in a substrate for multi-sheet transistors. The semiconductor material being patterned includes alternating layers 1422 and 1424 of silicon germanium located between layers 1421, 1423, and 1425 of silicon. In the embodiment shown, the fins (1405) are located on an oxide layer 1404 of the substrate, which is located on a base layer 1403. However, other embodiments may not include layer 1404.

After the stage of Figure 14, portions 1415-1418 are removed as well as the portion of layer 1407 on the fins. Portions of the SiGe layers 1424 and 1422 in each fin (1405) are removed to form openings (not shown) between layers 1421, 1423, and 1425. Gate material is then formed in the openings and around the portions of layers 1421, 1423, and 1425 to form transistor gates for a multi-sheet transistor. In other embodiments, the fins may have a different number of stacked layers of alternating silicon and silicon germanium. In other embodiments, the fins (1405) may be patterned by sidewall portions similar to portions 1101-1108 that are formed on the sidewalls of portions 1415-1418.

As shown and described herein, forming sidewall spacers on sidewalls of a cavity on a layer including carbon and inhibiting the formation of spacer material on a bottom surface portion during the material forming process may provide for a method for forming an opening that has a reduced lateral width from a photolithographically defined opening that has a larger lateral width. Accordingly, features of a semiconductor device may be made that have a smaller lateral width than the critical dimension. Utilizing an ADL process for forming the spacers may provide for a tighter control of the spacer width.

As disclosed herein, a first structure is "directly over" a second structure if the first structure is located over the second structure in a line having a direction that is perpendicular with a generally planar major side of the wafer or substrate. For example, in Figure 12, spacer portion 1101 is directly over fin 1201. Spacer portion 1108 is not directly over fin 1201. As disclosed herein, a first structure is "directly beneath" or "directly under" a second structure if the first structure is located beneath the second structure in a line having a direction that is perpendicular with a generally planar major side of the wafer or substrate. For example, in Figure 12, fin 1201 is directly beneath spacer portion 1101. Fin 1201 is not directly beneath spacer portion 1108. One structure is "directly between" two other structures in a line if the two structures are located on opposite sides of the one structure in the line. For example, in Figure 12, spacer portion 1105 is located directly between spacer portion 1108 and spacer portion 1101 in a line in the cut away side view of Figure 12. Substrate 903 is not located directly between spacer portions 1101 and 1108 in a line. A first structure is "directly lateral" to a second structure if the first structure and second structure are located in a line having a direction that is parallel with a generally planar major side of the wafer or substrate. For example, spacer portions 1101 and 1108 are directly lateral to each other. One structure is "directly laterally between" two other structures if the two structures are located on opposite sides of the one structure in a line that is parallel with a generally planar major side of the wafer or substrate. For example, in Figure 12, spacer portion 1105 is located directly laterally between spacer portions 1101 and 1108. A surface is at a "higher elevation" than another surface if that surface is located closer to the top of the active side of a wafer or integrated circuit in a line having a direction that is perpendicular with the generally planar major side of the wafer or integrated circuit. In the view of Figure 4, the active side of wafer 101 is the top side of the Figure 4. For example, layer 108 is at a higher elevation than spacer 301.

Features specifically shown or described with respect to one embodiment set forth herein may be implemented in other embodiments set forth herein.

In one embodiment, a method includes forming a layer including carbon over a substrate including semiconductor material, forming a first layer over the layer including carbon, and forming a first opening in the first layer. The first opening has a first lateral dimension in a first lateral direction. The method includes removing material of the layer including carbon through the first opening to form a cavity in the layer including carbon and forming a sidewall spacer structure. The forming a sidewall spacer structure includes performing a material forming process that forms sidewall spacer material on sidewalls of the layer including carbon of the cavity. The sidewall spacer material is inhibited from forming on a bottom surface portion of the cavity during the material forming process. The sidewall spacer structure defines a second opening exposing the bottom surface portion. The second opening having a second lateral dimension in the first lateral direction that is less than the first lateral dimension. In embodiments, the method further comprises, after the performing the material forming process, removing at least portions of the layer forming carbon laterally adjacent to the sidewall spacer structure; forming sidewall spacers of a second sidewall spacer material on the sidewalls of the sidewall spacer structure; after forming the sidewall spacers of the second sidewall spacer material, removing the sidewall spacer structure; using the sidewall spacers of the second sidewall spacer material as a mask to define the at least one fin.

In embodiments, the method further comprises implanting dopants into the substrate through the second opening wherein the sidewall spacer structure inhibits dopants from being implanted into the substrate. The method may further comprise: after the performing the material forming process, removing the layer including carbon.

In another embodiment, a method includes forming a layer including carbon over a wafer substrate including semiconductor material, forming a first layer over the layer including carbon, and forming a first opening in the first layer using a photolithographic process. The first opening has a first lateral dimension in a first lateral direction. The method includes removing material of the layer including carbon through the first opening to form a cavity in the layer including carbon and forming a sidewall spacer structure using a material forming process that forms sidewall spacer material on sidewalls of the cavity of the material including carbon. The sidewall spacer material is inhibited from forming on a bottom surface portion of the cavity. The sidewall spacer structure defines a second opening exposing the bottom surface portion, the second opening having a second lateral dimension in the first lateral direction that is less than the first lateral dimension. The method includes after the forming a sidewall spacer structure, singulating the wafer into a plurality of integrated circuits. In embodiments, the method further comprises after performing the material forming process but prior to the singulating, removing at least a portion of the layer including carbon and the sidewall spacer material formed.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the true spirit and scope of this invention.

## Claims

1. A method comprising:
forming a layer including carbon over a substrate including semiconductor material;
forming a first layer over the layer including carbon;
forming a first opening in the first layer, the first opening having a first lateral dimension in a first lateral direction;
removing material of the layer including carbon through the first opening to form a cavity in the layer including carbon;
forming a sidewall spacer structure, wherein the forming a sidewall spacer structure includes performing a material forming process that forms sidewall spacer material on sidewalls of the layer including carbon of the cavity, wherein the sidewall spacer material is inhibited from forming on a bottom surface portion of the cavity during the material forming process, wherein the sidewall spacer structure defines a second opening exposing the bottom surface portion, the second opening having a second lateral dimension in the first lateral direction that is less than the first lateral dimension.

2. The method of claim 1 wherein the layer including carbon includes amorphous carbon.

3. The method of claim 1 or 2 wherein the sidewall spacer material includes at least one of the group consisting of TiN, TiO₂, HfO₂, Ru, Pt, Al₂O₃.

4. The method of any preceding claim wherein the material forming process is characterized as an atomic layer deposition process.

5. The method of any preceding claim further comprising:
after the performing the material forming process, forming a second material in the second opening.

6. The method of claim 5 wherein the second material is characterized as a conductive material.

7. The method of claim 5 or 6 wherein the second material is characterized as a semiconductor material.

8. The method of any of claims 5 to 7 wherein the second material is characterized as a transistor control electrode material.

9. The method of any preceding claim wherein the bottom surface portion is a portion of the layer including carbon that was treated with hydrogen after the forming the cavity.

10. The method of claim 9 wherein after the forming the sidewall spacer structure, etching at least a portion of the bottom surface portion through the second opening to expose the substrate.

11. The method of any preceding claim wherein the bottom surface portion is made of a material different than the layer containing carbon.

12. The method of claim 11 wherein the bottom surface portion is treated with an inhibitor to inhibit formation of the spacer material during the material forming process.

13. The method of claim 12 wherein the inhibitor includes a short-chain amino-silane that inhibits formation of the spacer material during the material forming process.

14. The method of any preceding claim further comprising using the sidewall spacer structure to form at least one fin including semiconductor material.

15. The method of claim 14 wherein at least a portion of the sidewall spacer structure formed in the cavity is used as a mask to define a fin of the at least one fin.
